# EUROPEAN PATENT SPECIFICATION

(11) **EP 0 930 666 B1**
(45) Date of publication and mention of the grant of the patent: **09.08.2006**
(21) Application number: 99100831.9
(22) Date of filing: 18.01.1999
(51) Int. Cl.: H01P 5/04, H01P 1/208

(54) **Dielectric filter and dielectric duplexer**
Dielektrisches Filter und dielektrischer Duplexer
Filtre diélectrique et duplexeur diélectrique

(30) Priority: 20.01.1998 JP 886098
(43) Date of publication of application: 21.07.1999
(73) Proprietor: MURATA MANUFACTURING CO., LTD., Nagaokakyo-shi Kyoto-fu 617-8555 (JP)
(72) Inventor: Kubota, Kazuhiko, Nagaokakyo-shi, Kyoto-fu 617-8555 (JP); Ise, Tomoyuki, Nagaokakyo-shi, Kyoto-fu 617-8555 (JP)
(74) Representative: Schoppe, Fritz

(56) References cited:
- US-A- 2 431 941
- US-A- 4 727 342
- PATENT ABSTRACTS OF JAPAN vol. 8, no. 70 (E-235), 3 April 1984 & JP 58 218201 A (ALPS DENKI KK), 19 December 1983
- A.B. BERESKIN: "MULTI-SCREW TUNER FOR ANY MISMATCH" MICROWAVE JOURNAL., vol. 26, no. 8, August 1983, pages 133-141, XP002099367 DEDHAM US
- PATENT ABSTRACTS OF JAPAN vol. 15, no. 58 (E-1032), 12 February 1991 & JP 02 285702 A (MATSUSHITA ELECTRIC IND. CO. LTD.), 26 November 1990

## Description

### BACKGROUND OF THE INVENTION

### 1. Field of the Invention

The present invention relates to a dielectric filter and a dielectric duplexer for use in a communication base station or the like.

### 2. Description of the Related Art

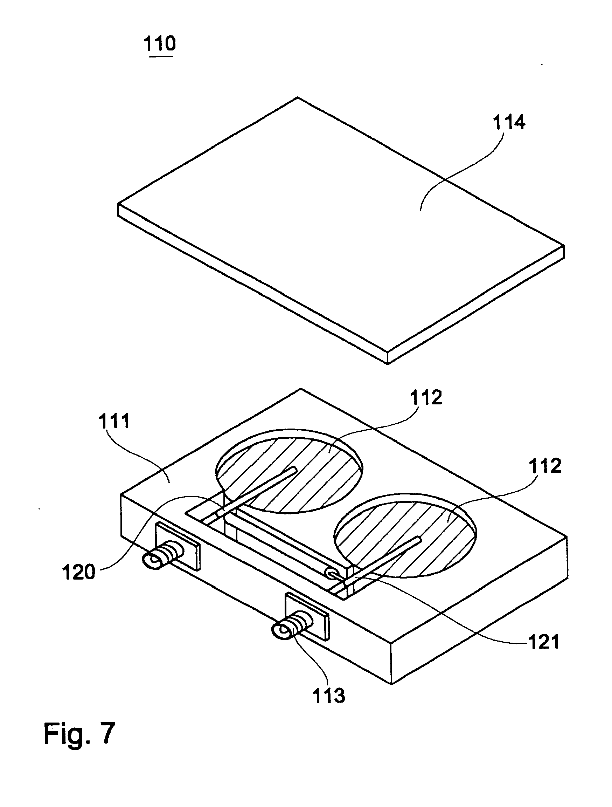

A dielectric filter relating to the present invention is shown in Fig. 7. Although this dielectric filter is described in copending U. S. Pat. Application No. 924040, this dielectric filter was not known yet in the art at the time when the invention, on the basis of which the priority of the present invention is claimed, was filed as Japanese Patent Application No. H-10-8860.

Fig. 7 is a perspective view of the dielectric filter 110. In this figure, an upper lid 114 is removed so that the internal structure can be seen. The dielectric filter shown herein is, by way of example, of the two-stage band-rejection filter type including two disk-shaped dielectrics 112 disposed side by side in a shielding cavity frame 111.

The dielectric filter 110 includes a shielding cavity frame 111 formed of metal, a dielectric 112 disposed in the shielding cavity frame 111, and external coupling means 120. The dielectric 112 is formed of ceramic in a disk shape and electrodes are formed of silver or the like on two opposite upper and lower surfaces thereof. The lower surface of the dielectric 112 is fixed via solder or the like to the inner bottom surface of the shielding cavity frame 111 thereby achieving electric connection. The external coupling means 120 includes an electric probe 121 made of a metal wire. The electric probe 121 is disposed in such a manner that it extends in a space between the upper surface of the dielectric 112 and the shielding cavity frame 111 without having contact with either the dielectric 112 or the shielding cavity frame 111. By employing the above structure, it becomes possible to reduce the current flowing through the shielding cavity frame 111 thereby reducing the loss due to such a current thus achieving a TM-mode dielectric filter having a small size in height and having high unloaded Q.

The electric probe 121 is connected via solder to an external connector 113 attached to the shielding cavity frame 111 so that a signal is input and output via the electric probe 121. That is, a signal is supplied via a cable connected to the external connector 113 and is passed through the electric probe 121. The electric probe 121 is coupled with the dielectric 112 via capacitance created between the electric probe 121 and the electrode of the dielectric 112. The dielectric 112 coupled with the electric probe 121 has resonance and thus serves as a band-rejection filter. The resultant signal is output through a cable connected to another external connector 113.

In the above-described dielectric filter, the coupling between the electric probe and the dielectric is realized via the capacitance between the electric probe and the dielectric. Thus, the strength of the coupling depends on the capacitance between the electric probe and the dielectric. The capacitance is determined by the distance between the electric probe and the dielectric, the areas of surfaces facing each other, and the dielectric constant of a substance existing between them. The attenuation varies with the change in the strength of the coupling, and the characteristic of the dielectric filter vary in such a manner that the filter has a band-rejection or bandpass characteristic with a wide bandwidth when the coupling is strong while the bandwidth becomes narrow when the coupling is weak. Therefore, to achieve a dielectric filter having desired characteristics, it is required to adjust the coupling between the electric probe and the dielectric. That is, it is required to adjust the capacitance between the electric probe and the dielectric.

In the above-described dielectric filter, the electric probe made of a metal wire is used as the external coupling means. The capacitance may be varied, as described above, by varying the distance between the electric probe and the dielectric, the areas of the surfaces, and/or the dielectric constant. However, it is difficult to change the location of the electric probe connected to the external connector because it is difficult to change the location of the external connector attached to the shielding cavity frame. The dielectric constant of air is impossible to change. Thus, a most practical manner of adjusting the capacitance between the electric probe and the dielectric is to change the length of the electric probe thereby changing the areas of the surfaces facing each other.

However, it is a troublesome process to adjust the length of the electric probe by cutting the electric probe for each dielectric or for each dielectric filter including the dielectric. Furthermore, if once the electric probe is cut to a too short length, it is impossible to make a readjustment to increase the capacitance.

Furthermore, an electrical discharge occurs through air existing between the electric probe and the dielectric when the potential difference between them exceeds the dielectric strength of air. Such a discharge can cause a difference in the characteristic of the electrode or the electric probe of the dielectric filter.

JP 58 218201 A describes a method for an adjustment of the distribution of an electromagnetic field within a waveguide. An insulator is moved up or down within the waveguide in order to adjust the distribution of the electromagnetic field within the waveguide.

EP-A-1-0 101 369 describes a filter comprising a housing, which functions as a waveguide. Dielectric resonators are arranged within the housing. Connectors are arranged at both ends of the filter and comprise antennas, which are arranged in the direction of the propagation of the waves within the waveguide.

WO-A-9220116 describes a dielectric resonator, which comprises a housing, a dielectric resonator and an inner conductor. The resonator comprises two cylindrical discs, which are positioned with their planar surfaces against each other, so that they are radially displaceable with respect to each other for varying the shape of the resonator and for adjusting the resonance frequency of the resonator.

FR-A-2 521 785 describes a filter comprising a housing made of metal plates, dielectric resonators and a connector with an antenna. The antenna is part of an isolating connector. The resonators are arranged on dielectric support members. Control elements are arranged above a top surface of the resonators.

In view of the problems described above, it is an object of the present invention to provide a dielectric filter and dielectric duplexer whose characteristics can be more easily adjusted and which have higher reliability.

This object is achieved by a dielectric filter according to claim 1 and a dielectric duplexer according to claim 4.

According to an aspect of the invention, to achieve the above object, there is provided a dielectric filter including a shielding cavity frame having electric conductivity, a dielectric having electrodes formed on two opposing faces and disposed in the shielding cavity frame, and external coupling means, wherein the external coupling means includes an electric probe at least a part of which is covered with a covering dielectric.

In this dielectric filter, the covering dielectric covering the electric probe is preferably movable.

The movability of the covering dielectric may be achieved by connecting the covering dielectric to the electric probe by means of mating via screw threads.

According to another aspect of the invention, there is provided a dielectric duplexer including a shielding cavity frame having electric conductivity, a dielectric having electrodes formed on two opposing faces and disposed in the shielding cavity frame, external coupling means, input/output connection means and antenna connection means connected to the coupling means, wherein the external coupling means includes an electric probe at least a part of which is covered with a covering dielectric.

In this dielectric duplexer, the covering dielectric covering the electric probe is preferably movable.

The movability of the covering dielectric may be achieved by connecting the covering dielectric to the electric probe by means of mating via screw threads.

In the above-described dielectric filter and the dielectric duplexer according to the invention, it is possible to easily adjust the capacitance between the electric probe and the dielectric. Furthermore, it is possible to increase the dielectric strength between the electric probe and the dielectric.

### BRIEF DESCRIPTION OF THE DRAWINGS

Fig. 1 is a perspective view of a dielectric filter according to the present invention;
Fig. 2 is a perspective view of external coupling means according to the present invention;
Fig. 3 is a perspective view of a second embodiment of a dielectric filter according to the present invention;
Fig. 4 is a perspective view of external coupling means of the second embodiment according to the present invention;
Fig. 5 is a perspective view of a third embodiment of a dielectric filter according to the present invention;
Fig. 6 is a perspective view of a dielectric duplexer according to the present invention; and
Fig. 7 is a perspective view of an another type of dielectric filter.

### DESCRIPTION OF THE PREFERRED EMBODIMENTS

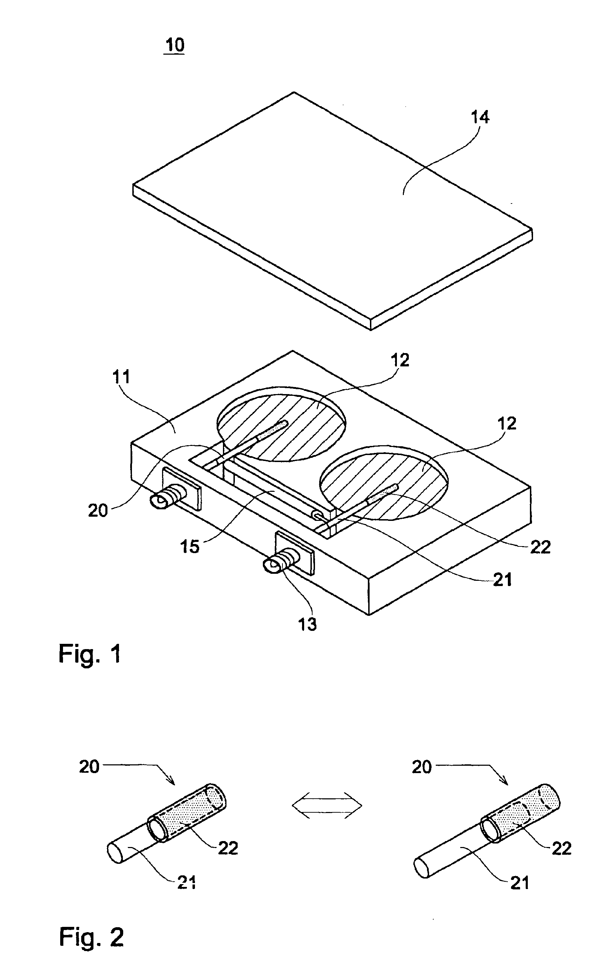

Referring now to Fig. 1, an embodiment of a dielectric filter according to the present invention is described below. Fig. 1 is a perspective view of the dielectric filter 10 according to the present invention. In the figure, an upper lid 14 is removed so that the internal structure can be seen.

The dielectric filter 10 includes a shielding cavity frame 11, disk-shaped dielectrics 12, and external coupling means 20. The shielding cavity frame 11 is formed of metal and external connectors 13 are attached to it so that a signal is input and output from and to the outside via cables. The external coupling means 20 are connected to the respective external connectors 13 via solder. Each dielectric 12 is formed of ceramic in a disk shape and electrodes are formed on it by means of coating and baking silver paste on two opposing surfaces. The lower surface of each dielectric 12 is fixed via solder or the like to the inner bottom face of the shielding cavity frame 11 thereby achieving electric connection. Alternatively, the dielectric 12 may be soldered to a ground plate or the like and may be placed in the shielding cavity frame 11. In this embodiment, two dielectrics 12 are placed side by side and these two dielectrics 12 are connected to each other via a 1/4-transmission line 15 so that the dielectric filter 10 acts as a two-stage band-rejection filter. The shielding cavity frame 11 may also be produced by forming an electrically conductive layer on the surface of a ceramic material. The dielectric 12 may also be formed into a square shape. The electrodes on the two opposing surfaces of the dielectric 12 may be formed into the structure of a multilayer thin film so as to reduce the loss.

The external coupling means 20 includes an electric probe 21 made up of a metal wire a desired part of which is covered with a resin or the like 22 serving as a covering dielectric. As for the resin 22, polyprene or a similar resin is employed which can be easily formed into a desired shape and which has elasticity which makes it easy to perform the adjustment which will be described later. The resin 22 is formed into the shape of a cylinder with a diameter greater than the diameter of the electric probe 21 wherein a through-hole is formed such that it extends from one end of the cylinder to the opposite end or a semi-through-hole is formed such that one end of the semi-through-hole is closed with one end of the cylinder. The electric probe 21 is inserted into this hole and the resin 22 is moved to a desired position so that a desired part of the electric probe 21 is covered with the resin 22 as shown in Fig. 2. Thus, the resin 22 is present between the electric probe 21 and the dielectric 12. The resin 22 has a higher dielectric strength and a greater dielectric constant than air. Therefore, covering the electric probe 21 with the resin 22 results in a reduction in the probability that a discharge will occur between the electric probe 21 and the dielectric 12. Furthermore, the capacitance can be varied by varying the dielectric constant between the electric probe 21 and the dielectric 12 using the resin 22. More specifically, by varying the relative length of the part of the electric probe 21 inserted in the resin 22, it is possible to vary the capacitance and thus the strength of the coupling between the electric probe 21 and the dielectric 12. Thus it becomes possible to make an adjustment to obtain desired band characteristics.

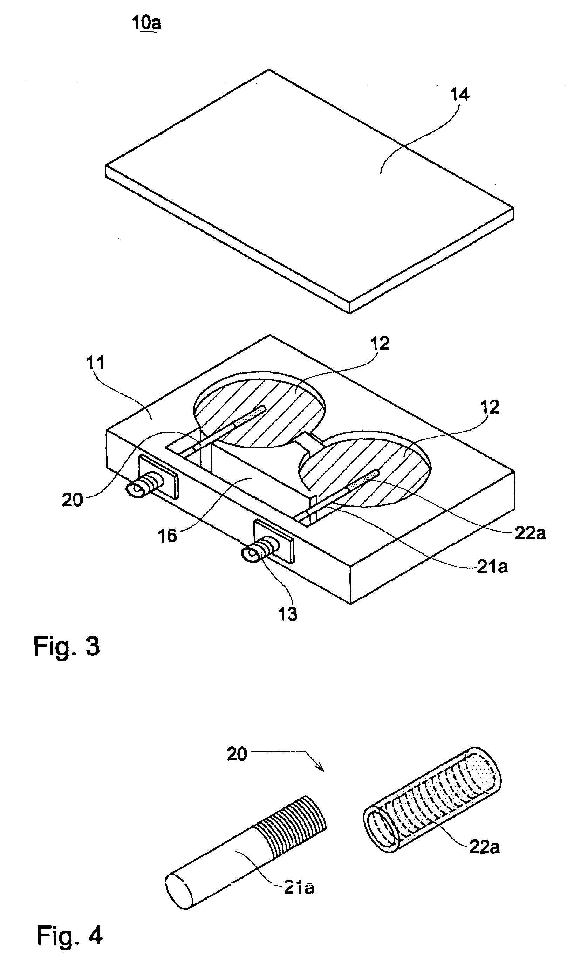

Referring now to Figs. 3 and 4, a second embodiment of the present invention is described below. Similar parts to those in the previous embodiment are denoted by similar reference numerals and they are not described in further detail herein.

As illustrated in Fig. 3, the dielectric filter of the present embodiment includes two disk-shaped dielectrics 12 each having electrodes formed on two opposing surfaces and disposed side by side in a shielding cavity frame 11. The two dielectrics 12 are coupled to each other via a capacitive coupling member 16. The dielectric filter 10a having the structure described above acts as a two-stage bandpass filter.

Fig. 4 is a perspective view illustrating an electric probe 21a made up of a metal wire and also illustrating a resin 22a covering the electric probe 21a, according to the present embodiment. As shown in Fig. 4, the electric probe 21a and the resin 22a are threaded such that the electric probe 21a serves as a male screw and the resin 22a acts as a female screw. The resin 22a is screwed onto the electric probe 21a thereby connecting them to each other. This allows the resin 22a to be easily connected to the electric probe 21a in a firm fashion so that the resin 22a is not moved by external vibrations or a mechanical shock. That is, the strength of the coupling between the electric probe 21a and the dielectric 12 is not changed by an external disturbance.

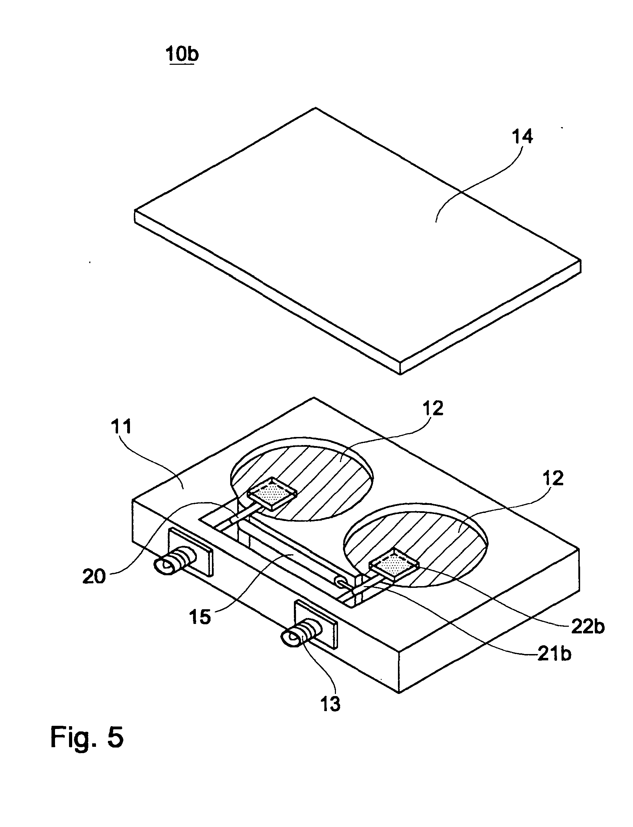

Referring now to Fig. 5, a third embodiment of the present invention is described below. Also in this figure, an upper lid 14 is removed so that the internal structure of a dielectric filter 10b can be seen. As in the first embodiment, two disk-shaped dielectrics 12 are connected to each other via a /4-transmission line 15 so that the dielectric filter 10b acts as a two-stage band-rejection filter. Similar parts to those in the previous embodiments are denoted by similar reference numerals and they are not described in further detail herein.

In the present embodiment, each external coupling means 20 includes an electric probe 21b made up of a metal wire a desired part of which is covered with a resin or the like 22b serving as a covering dielectric. As for the resin 22b, polyprene or a similar resin is employed which can be easily formed into a desired shape and which has elasticity which makes it easy to perform the adjustment which will be described later. This resin 22b has a hole corresponding to the electric probe 21b. The electric probe 21b is inserted into the hole and the resin 22b is moved to a desired position so that a desired part of the electric probe 21b is covered with the resin 22b. Thus, the resin 22b is present between the electric probe 21b and the dielectric 12. The resin 22b has a higher dielectric strength and a greater dielectric constant than air. Therefore, covering each electric probe 21b with the resin 22b results in a reduction in the probability that a discharge will occur between the electric probe 21b and the dielectric 12. Furthermore, the capacitance can be varied by varying the dielectric constant between the electric probe 21b and the dielectric 12 using the resin 22b. More specifically, by varying the relative length of the part of the electric probe 21b inserted in the resin 22b, it is possible to vary the capacitance and thus the strength of the coupling between the electric probe 21b and the dielectric 12. Thus, it is possible to make an adjustment such that the dielectric filter has desired characteristics. Because the external coupling means 20 is formed into the shape of a plate, it is easier to obtain desired capacitance than in the first embodiment.

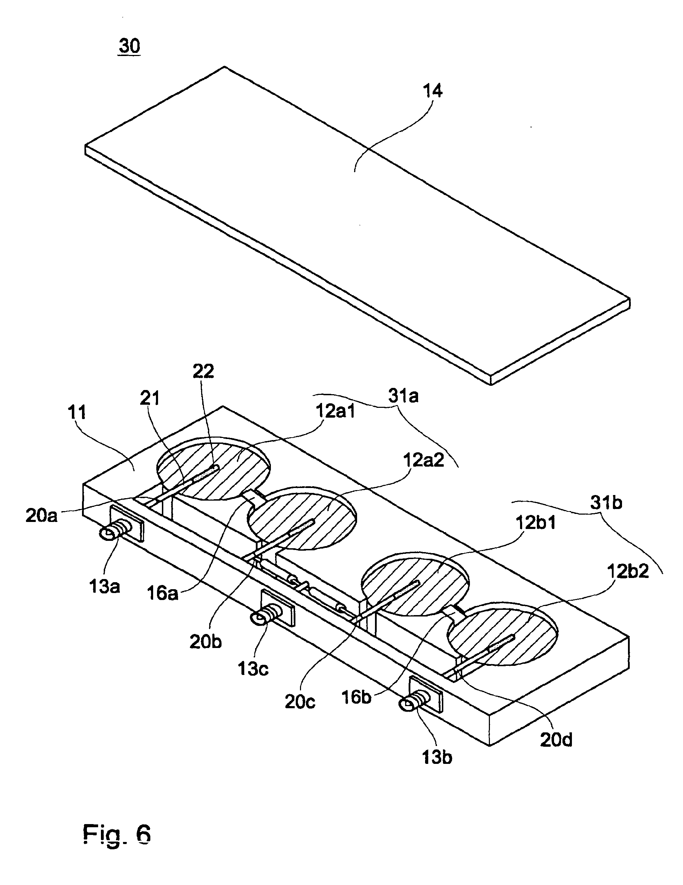

Referring to Fig. 6, an embodiment of a dielectric duplexer according to the present invention is described below. Similar parts to those in the previous embodiments are denoted by similar reference numerals and they are not described in further detail herein.

As illustrated in Fig. 6, a dielectric duplexer 30 includes a first dielectric filter 31a and a second dielectric filter 31b wherein the first dielectric filter 31 includes two disk-shaped dielectrics 12a1 and 12a2 disposed in a shielding cavity frame 11 and the second dielectric filter 31 includes two disk-shaped dielectrics 12b1 and 12b2. The two dielectrics 12a1 and 12a2 of the first dielectric filter 31a are coupled to each other via a capacitive coupling member 16a so that the first dielectric filter 31a serves as a transmitting bandpass filter. The two dielectrics 12b1 and 12b2 of the second dielectric filter 31a have resonant frequencies different from those of the dielectrics 12a1 and 12a2 of the first dielectric filter 31a and are coupled to each other via a capacitive coupling member 16b so that the second dielectric filter 31b serves as a receiving bandpass filter. The external coupling means 20a coupled with the dielectric 12a1 of the first dielectric filter 31a is connected to an external connector 13a which is connected to an external transmitting circuit. The external coupling means 20d coupled with the dielectric 12b2 of the second dielectric filter 31b is connected to an external connector 13b which is connected to an external receiving circuit. The external coupling means 20b coupled with the dielectric 12a2 of the first dielectric filter 31a and the external coupling means 20c coupled with the dielectric 12b1 of the second dielectric filter 31b are connected to an external connector 13c which is connected to an external antenna.

The external coupling means 20a, 20b, 20c, and 20d each include an electric probe 21 made up of a metal wire a desired part of which is covered with a resin or the like 22 serving as a covering dielectric. By covering the electric probes 21 with resins 22, it becomes possible to reduce the probability that a discharge will occur between the electric probes 21 and the dielectrics 12a1, 12a2, 12b1, and 12b2. Furthermore, the capacitance can be varied by varying the dielectric constant between the electric probe 21s and the dielectrics 12a1, 12a2, 12b1, and 12b2, using the resins 22. More specifically, by varying the relative length of the part of the electric probes 21 inserted in the resins 22, it is possible to vary the capacitance and thus the strength of the coupling between the electric probes 21 and the dielectrics 12a1, 12a2, 12b1, and 12b2. Thus it becomes possible to make an adjustment to obtain desired band characteristics.

As described above, the present invention has various advantages. That is, in the present invention, the electric probe made of metal and serving as the external coupling means in the dielectric filter or dielectric duplexer is covered with the covering dielectric thereby increasing the dielectric strength between the electric probe and the dielectric thus reducing the probability that a discharge will occur.

The covering dielectric on the electric probe is provided in a movable fashion whereby the part of the electric probe covered with the covering dielectric can be varied. This makes it possible to easily adjust the strength of the coupling between the electric probe and the dielectric without having to cut each electric probe to a shorter length. That is, by varying the coupling strength, it is possible to make an adjustment such that the pass band or the rejection band of the dielectric filter or the dielectric duplexer has a greater or smaller bandwidth as required. Thus, it is possible to easily produce dielectric filters and dielectric duplexers having desired characteristics depending on applications in which they are used.

Furthermore, by connecting the covering dielectric to the electric probe by means of mating via screw threads, it becomes possible to prevent the length of the part of the electric probe covered with the covering dielectric from varying after completion of the characteristic adjustment. That is, after adjusting the characteristics of the dielectric filter, the position of the covering dielectric on the electric probe is not varied by an external shock or vibrations. Thus, it is possible to prevent the dielectric filter and the dielectric duplexer from having a change in characteristics due to an external disturbance.

As described above, the present invention provides a dielectric filter and a dielectric duplexer whose characteristics can be easily adjusted and which have good long-term reliability.

## Claims

1. A dielectric filter including a shielding cavity frame having electric conductivity, a dielectric having electrodes formed on opposing faces and disposed in said shielding cavity frame, and external coupling means, said dielectric filter being **characterized in that** said external coupling means includes an electric probe at least a part of which is covered with a covering dielectric which adjusts the capacitive coupling between said electric probe and said dielectric of said filter.

2. A dielectric filter according to Claim 1, wherein the covering dielectric covering said electric probe is movable.

3. A dielectric filter according to Claim 1 or 2, wherein the movability of said covering dielectric is achieved by connecting said covering dielectric to said electric probe by means of mating via screw threads.

4. A dielectric duplexer including a shielding cavity frame having electric conductivity, a dielectric having electrodes formed on two opposing faces and disposed in said shielding cavity frame, external coupling means, input/output connection means and antenna connection means connected to said coupling means, said dielectric duplexer being **characterized in that** said external coupling means includes an electric probe at least a part of which is covered with a covering dielectric which adjusts the capacitive coupling between said electric probe and said dielectric of said duplexer.

5. A dielectric duplexer according to Claim 4, wherein the covering dielectric covering said electric probe is movable.

6. A dielectric duplexer according to Claim 4 or 5, wherein the movability of said covering dielectric is achieved by connecting said covering dielectric to said electric probe by means of mating via screw threads.

## Patentansprüche

1. Ein dielektrisches Filter, das einen abschirmenden Hohlraumrahmen mit einer elektrischen Leitfähigkeit, ein Dielektrikum mit Elektroden, die auf gegenüberliegenden Flächen gebildet und in dem abschirmenden Hohlraumrahmen angeordnet sind, und eine externe Kopplungseinrichtung umfasst, wobei das dielektrische Filter **dadurch gekennzeichnet ist, dass** die externe Kopplungseinrichtung eine elektrische Sonde umfasst, wobei zumindest ein Teil derselben mit einem abdeckenden Dielektrikum abgedeckt ist, das die kapazitive Kopplung zwischen der elektrischen Sonde und dem Dielektrikum des Filters einstellt.

2. Ein dielektrisches Filter gemäß Anspruch 1, bei dem das abdeckende Dielektrikum, das die elektrische Sonde abdeckt, bewegbar ist.

3. Ein dielektrisches Filter gemäß Anspruch 1 oder 2, bei dem die Bewegbarkeit des abdeckenden Dielektrikums erreicht wird durch Verbinden des abdeckenden Dielektrikums mit der elektrischen Sonde mit Hilfe einer Zusammenpassung über Schraubengewinde.

4. Ein dielektrischer Duplexer, der einen abschirmenden Hohlraumrahmen mit elektrischer Leitfähigkeit, ein Dielektrikum mit Elektroden, die auf zwei gegenüberliegenden Flächen gebildet und in dem abschirmenden Hohlraumrahmen angeordnet sind, eine externe Kopplungseinrichtung, Eingabe-/Ausgabe-Verbindungseinrichtung und eine Antennenverbindungseinrichtung, verbunden mit der Kopplungseinrichtung, umfasst, wobei der dielektrische Duplexer **dadurch gekennzeichnet ist, dass** die externe Kopplungseinrichtung eine elektrische Sonde umfasst, wobei zumindest ein Teil derselben mit einem abdeckenden Dielektrikum abgedeckt ist, das die kapazitive Kopplung zwischen der elektrischen Sonde und dem Dielektrikum des Duplexers einstellt.

5. Ein dielektrischer Duplexer gemäß Anspruch 4, bei dem das abdeckende Dielektrikum, das die elektrische Sonde abdeckt, bewegbar ist.

6. Ein dielektrischer Duplexer gemäß Anspruch 4 oder 5, bei dem die Bewegbarkeit des abdeckenden Dielektrikums erreicht wird durch Verbinden des abdeckenden Dielektrikums mit der elektrischen Sonde mit Hilfe einer Zusammenpassung über Schraubengewinde.

## Revendications

1. Filtre diélectrique comprenant un cadre à cavité de blindage présentant une conductivité électrique, un diélectrique ayant des électrodes formées sur des faces opposées et disposé dans ledit cadre à cavité de blindage, et des moyens de couplage extérieurs, ledit filtre diélectrique étant **caractérisé en ce que** lesdits moyens de couplage extérieurs comprennent une sonde électrique dont au moins une partie est recouverte par un diélectrique de recouvrement réglant le couplage capacitif entre la sonde électrique et ledit diélectrique dudit filtre.

2. Filtre diélectrique selon la revendication 1, dans lequel le diélectrique de recouvrement recouvrant ladite sonde électrique est mobile.

3. Filtre diélectrique selon la revendication 1 ou 2, dans lequel la mobilité dudit diélectrique de recouvrement est obtenue en connectant ledit diélectrique de recouvrement à ladite sonde électrique à l'aide de filetages en regard.

4. Duplexeur diélectrique comprenant un cadre à cavité de blindage présentant une conductivité électrique, un diélectrique ayant des électrodes formées sur deux faces opposées et disposé dans ledit cadre à cavité de blindage, des moyens de couplage extérieurs, des moyens de connexion d'entrée/sortie et des moyens de connexion d'antenne connectés auxdits moyens de couplage, ledit duplexeur diélectrique étant **caractérisé en ce que** lesdits moyens de couplage extérieurs comprennent une sonde électrique dont au moins une partie est recouverte par un diélectrique de recouvrement réglant le couplage capacitif entre ladite sonde électrique et ledit diélectrique dudit duplexeur.

5. Duplexeur diélectrique selon la revendication 4, dans lequel le diélectrique de recouvrement recouvrant ladite sonde électrique est mobile.

6. Duplexeur diélectrique selon la revendication 4 ou 5, dans lequel la mobilité dudit diélectrique de recouvrement est obtenue en connectant ledit diélectrique de recouvrement à ladite sonde électrique par des filetages en regard.
